Europäisches Patentamt

European Patent Office

Office européen des brevets

(11) Publication number: **0 072 674**
**B1**

(12) **EUROPEAN PATENT SPECIFICATION**

(45) Date of publication of patent specification: **02.11.89**

(51) Int. Cl.⁴: **H 03 K 19/173**

(21) Application number: **82304273.4**

(22) Date of filing: **12.08.82**

(54) A semiconductor device having a gate array structure.

(30) Priority: **13.08.81 JP 127072/81**

(43) Date of publication of application:
**23.02.83 Bulletin 83/08**

(45) Publication of the grant of the patent:
**02.11.89 Bulletin 89/44**

(84) Designated Contracting States:
**DE FR GB**

(56) References cited:
**EP-A-0 021 661**
**US-A-3 912 914**

**ELECTRO/81 CONFERENCE RECORD, vol. 6,
7th-9th April 1981, pages 1-6 (16/4), New York,
US**

**IBM JOURNAL OF RESEARCH &
DEVELOPMENT, vol. 25, no. 2/3, May 1981,
pages 116-125, Armonk, US**

**ELECTRO/80 CONFERENCE RECORD, vol. 5,
13th-15th May 1980, pages 1-7 (22/2), Boston,
US**

(73) Proprietor: **FUJITSU LIMITED**
**1015, Kamikodanaka Nakahara-ku
Kawasaki-shi Kanagawa 211 (JP)**

(72) Inventor: **Tanizawa, Tetsu
Dai-2-Yurigaoka-ryo 2-7-5 Chiyogaoka Asao-ku
Kawasaki-shi Kanagawa 215 (JP)**
Inventor: **Omichi, Hitoshi
Dai-2-Taihei-so 203 Shukugawara Tama-ku
Kawasaki-shi Kanagawa 214 (JP)**
Inventor: **Mitono, Yoshiharu
1-14-12 Sakuragaoka
Setagaya-ku Tokyo 156 (JP)**

(74) Representative: **Rackham, Stephen Neil et al
GILL JENNINGS & EVERY 53-64 Chancery Lane
London WC2A 1HN (GB)**

(56) References cited:
**IEEE SPECTRUM, vol. 19, no. 6, June 1982,
pages 38-45, IEEE, New York, US**

Courier Press, Leamington Spa, England.

## Description

The present invention relates to a semiconductor device having a gate array structure in which a macrocell is formed by connecting together a plurality of basic cells.

Generally, as a method of manufacturing a largescale integration circuit (LSI), a gate array method is used and this shortens the manufacturing period.

In this method, a standard semiconductor chip is used which includes a large number of logic gates formed in a matrix fashion. Then to tailor this standard semiconductor chip for a particular function wirings are connected to the logic gates to form the required logic circuit that the chip has to perform. The wiring pattern is usually designed using a digital computer and the wiring all lies on a predetermined grid in which the wiring routes lie only on lines running lengthwise and laterally in a matrix fashion. Furthermore, a first wiring layer includes only lengthwise wiring routes, a second wiring layer includes only lateral wiring routes and connections between the lines of the first and second wiring layers are made by means of plated through holes.

As the standard logic gate of this type of semiconductor device, a basic logic element, for example, a four-input NAND gate, can be used, and then by combining a plurality of these basic elements, the various kinds of logic circuits usually required can be constructed. For example, an AND gate can be constructed by using two such basic cells, and a flip-flop circuit can be constructed by using six such basic cells. A logic circuit which is constructed by using a plurality of basic cells and has a single logic function such as AND, flip-flop, NOR, or EXCLUSIVE OR is called a macro-cell. Each macro-cell can be considered to be a single element in itself, and, for example, when a flip-flop circuit is necessary in the formation of a logic circuit, a previously designed macro-cell having the logic function of a flip-flop circuit may be used to form a logic circuit by forming it on the semiconductor chip as a combination of the basic cells by means of the predetermined interconnections.

Conventionally, when a macro-cell is constructed by means of the above-mentioned gate array method, the smallest number of basic cells necessary for the formation of the macro-cell are used. Naturally, it has always been the aim of the designer to use the minimum number of basic cells for each macro-cell so leaving the greatest number of basic cells available for the formation of other logic functions. However, in the above-mentioned conventional method, there is a problem in that the density of the occupied terminals becomes so high that the computer is not able to discover a required wiring route, for example, between two macro-cells and thus the number of uncompleted wiring routes may be increased. Furthermore, even if the wiring routes are discovered, these routes may be very long because they include roundabout routes around macro-cells. When the required wiring routes are not discovered by the computer and remain uncompleted, it is necessary to complete them by hand, which is troublesome and results in misconnection and inequality. Also, when a wiring route is very long, signal transmission time is delayed and the stray capacity of the wiring is increased.

It has also been proposed to include some unused basic cells in at least some of the macro-cells and to then use these unused basic cells to provide a wiring path across the macro-cells. Such techniques are disclosed in Electro/81 Conference Record Volume 6, 7th to 9th April 1981, pages 1 to 6, (16/4) New York in an article by T. M. Goldsmith entitled "A Family of CMOS Arrays with TTL Performance"; and, also in the IBM Journal of Research and Development, Volume 25/3, May 1981, pages 116 to 125, in an article by A. H. Dansky entitled "Bipolar Circuit Design for a 5000 Circuit VLSI Gate Array".

According to this invention a semiconductor device having a gate array structure in which a semiconductor chip includes a large number of basic logic cells which are arranged in a matrix and are interconnected by wiring extending in two mutually perpendicular directions to produce a plurality of macro-cells which each have a particular logic function, the wiring also interconnecting the macro-cells to complete the device, is characterised in that at least one of the plurality of macro-cells includes arranged along one of the mutually perpendicular directions more of the basic logic cells than the minimum number which have to be connected together to perform the said particular logic function, in that the wiring passes through a basic cell of the at least one macro-cell in a direction perpendicular to the said one direction and in that every basic logic cell arranged in each of said at least one of the plurality of macro-cells includes a basic logic element arranged to carry out a logic function and has at least one input/output terminal connected by the wiring, so decreasing the density of occupied terminals of the macro-cell in the said one direction, thereby providing a greater number of wiring paths across the macro-cell in the direction perpendicular to the said one direction.

Examples of devices in accordance with this invention will now be described and contrasted with the prior art with reference to the accompanying drawings; in which:—

Figure 1 is a diagram showing the structure of a conventional macro-cell-forming a 4 wide-4 input AND-OR inverter together with its connection grid;

Figure 2 is a diagram showing the structure of a macro-cell-forming a 4-wide-4 input AND-OR inverter and its connection grid according to the present invention;

Figure 3 is a circuit diagram of a macro-cell of a 4-wide-6 input AND-OR inverter;

Figure 4 is a plan of the structure of a conventional 4 wide-6 input AND-OR inverter;

Figure 5 is a plan of the structure of a 4 wide-6 input AND-OR inverter according to the present invention;

Figure 6 is a logic diagram of a 4 wide-6 input AND-OR inverter; and,

Figure 7 is a schematic plan of the basic logic cells formed on the semiconductor chip.

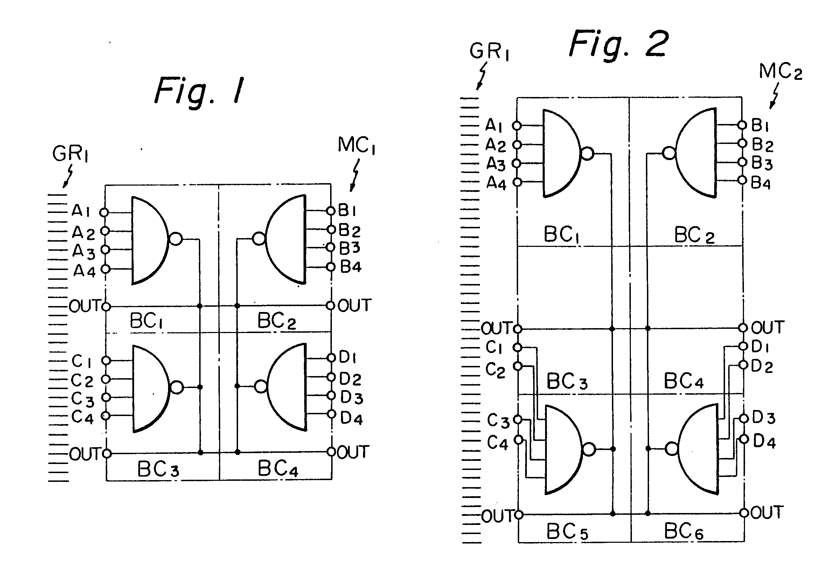

Macro-cell $MC_1$ of Fig. 1 is constructed by using four adjacent basic cells $BC_1$ through $BC_4$. Each basic celll has one 4-input NAND gate, and, therefore, at least four basic cells are necessary for constructing the macro-cell of a 4 wide-4 input AND-OR inverter. Terminals $A_1$ through $A_4$ are inputs of the NAND gate of basic cells $BC_1$, terminals $B_1$ through $B_4$ are inputs of the NAND gate of basic cell $BC_2$, terminals $C_1$ through $C_4$ are inputs of the NAND gate of basic cell $BC_3$, and terminals $D_1$ through $D_4$ are inputs of the NAND gate of basic cell $BC_4$. Terminals OUT are output terminals in each basic cells and are connected to each other. In the semiconductor chip on which macro-cell $MC_1$ is formed, a large number of basic cells are arranged in a matrix fashion, and on the basic cells two wiring layers are formed, one of which is provided for the lengthwise wiring lines and the other of which is provided for the lateral wiring lines. On these wiring layers, a wiring line can be drawn only on a predetermined grid, and lengthwise and lateral wiring lines can be connected by means of a through hole. In Fig. 1, the pitch of the above-mentioned grid is shown as $GR_1$. As can be seen from the figure, the density of the terminals in the lengthwise direction of macro-cell $MC_1$ is so high that the lateral line passing through macro-cell $MC_1$ may not be drawn on grid $GR_1$. In such a case, the wiring route must run around macro-cell $MC_1$, with the result that the length of the wiring line is increased.

Macro-cell $MC_2$ of Fig. 2 according to the present invention is constructed by using six basic cells $BC_1$ through $BC_6$, that is by using two more basic cells than were used to construct $MC_1$ of Fig. 1. Like macro-cell $MC_1$ macro-cell $MC_2$ forms a 4 wide-4 input AND-OR inverter. In macro-cell $MC_2$, cells $BC_1$ and $BC_2$ and every three terminals of basic cells $BC_3$, $BC_4$, $BC_5$, and $BC_6$ are used. Thus, in macro-cell $MC_2$ of Fig. 2, the density of the terminals in the lengthwise direction is substantially lower than that in macro-cell $MC_1$ of Fig. 1. Accordingly, the freedom of selection of the wiring route passing across macro-cell $MC_2$ is increased, and, therefore, design of the wiring pattern becomes easier.

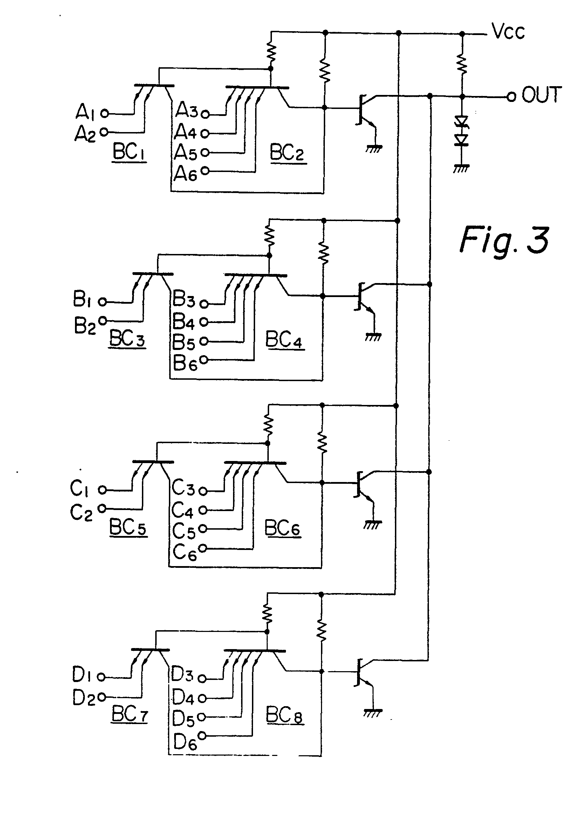

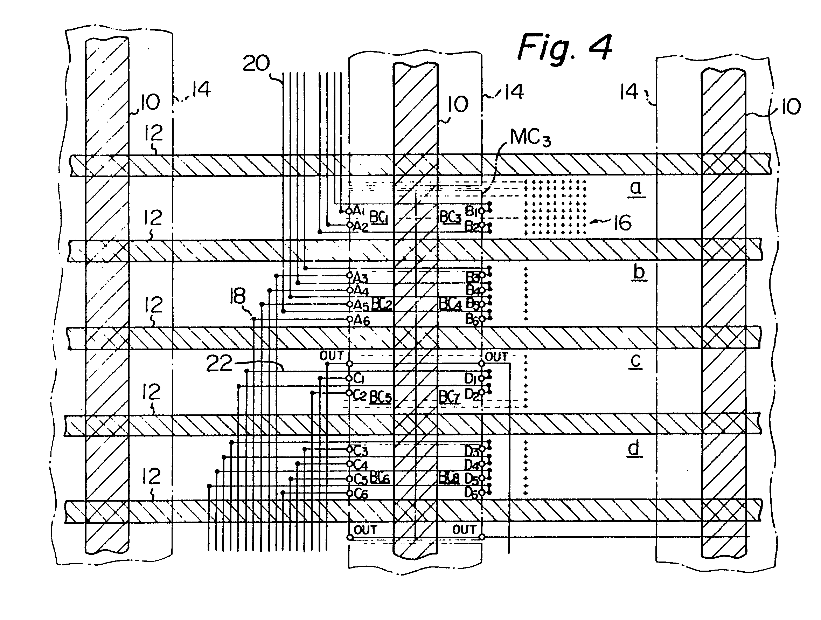

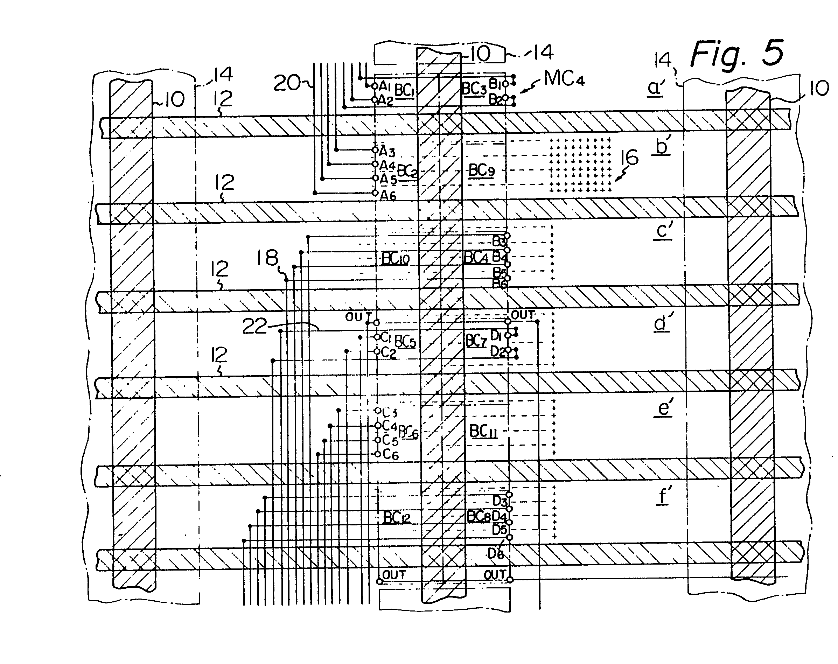

Another embodiment of the present invention is described with reference to Figs. 3, 4, 5, and 6. Figure 3 illustrates the circuit diagram of a 4 wide-6 input AND-OR inverter. Figure 4 illustrates the structure of a macro-cell having the logic function of a 4 wide-6 input AND-OR inverter which is constructed by means of a conventional method. Figure 5 illustrates the structure of a macro-cell having the logic function of a 4 wide-6 input AND-OR inverter which is constructed according to the present invention.

The 4 wide-6 input AND-OR inverter of Fig. 3 can be constructed by using eight basic cells, each of which has one 4-inputs NAND gate. Macro-cell $MC_3$ of Fig. 4 is constructed by using eight basic cells $BC_1$ through $BC_8$, the minimum number necessary for constructing the 4 wide-6 input AND-OR inverter. In Fig. 4, two rows of basic cells are arranged in the lengthwise direction. Along the rows of basic cells, a lengthwise pattern of voltage supply line 10 is formed in the first wiring line layer, and lateral patterns of ground wiring line 12 are formed in the second wiring layer. Voltage supply lines 10 are arranged in parallel with each other, as are ground wiring lines 12. Basic cell arrays 14 are arranged along voltage supply lines 10. Lengthwise wiring lines 20 can be drawn between adjacent voltage supply lines 10 and lateral wiring lines 22 can be drawn between adjacent ground wiring lines 12. Wiring lines 20 and 22 can be drawn on grid pattern 16, and one of lengthwise wiring lines 20 and one of lateral wiring lines 22 can be connected via through hole 18.

In macro-cell $MC_3$ of Fig. 4, the density of the terminals is very high, and most of the wiring routes in lateral wiring areas a, b, c, and d are used for leading out the terminals of macro-cell $MC_3$. Thus, the number of lateral wiring routes which can be used to pass through macro-cells $MC_3$ is 4 in area a, 0 in area b, 3 in area c, and 0 in area d, as shown by the broken lines.

On the other hand, macro-cell $MC_4$ of Fig. 5 is constructed by using 12 basic cells $BC_1$ through $BC_{12}$, including 4 extra basic cells $BC_9$ through $BC_{12}$. In macro-cell $MC_4$, the formation of two terminals on the same lateral wiring route on both sides of macro-cell $MC_4$ is avoided as much as possible, and the terminals on lateral wiring areas a', b', c', d', e', and f' are distributed as evenly as possible. Thus, the density of the terminals in the lengthwise direction can be decreased. The number of lateral wiring routes which can be used to pass through macro-cell $MC_4$ is 4 in area a', 4 in area b', 4 in area c', 3 in area d', 4 in area e', and 4 in area f', as shown by broken lines. Thus, in macro-cell $MC_4$, an unused lateral wiring route passing through macro-cell $MC_4$ can be found in all of wiring areas a' through f'.

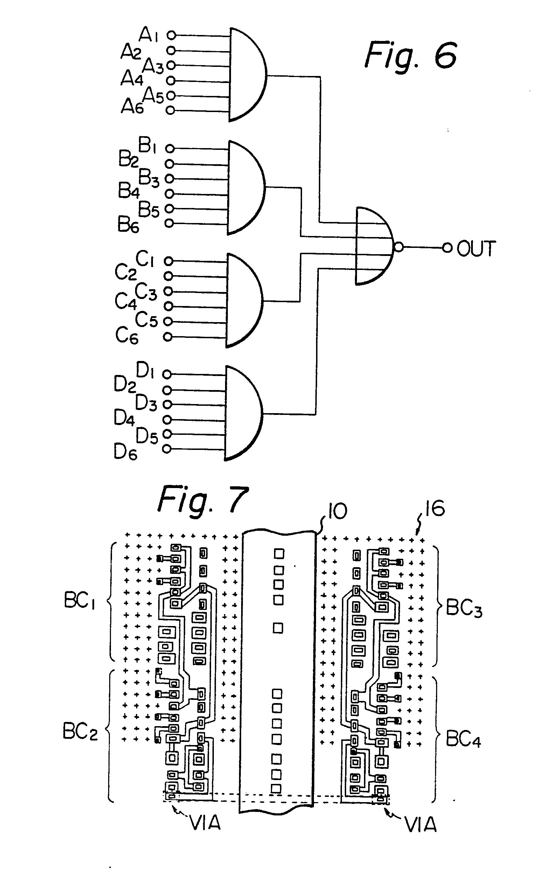

The logic diagram of macro-cell $MC_4$ of Fig. 5 is illustrated in Fig. 6. An example of a plan view of the actual wiring pattern of a macro-cell is illustrated in Fig. 7.

As described above, according to the present invention in a semiconductor device having a gate array structure, by constructing a macro-cell by using more than the necessary number of basic cells, the density of the terminals can be decreased and thus the design work for determining the desired wiring routes can be made easier. In addition, the wiring pattern can be drawn by a digital computer so that there are no unconnected wiring routes, and the quality of the wiring pattern can be improved.

## Claims

1. A semiconductor device having a gate array structure in which a semiconductor chip includes a large number of basic logic cells (BC) which are arranged in a matrix and are interconnected by wiring (18, 20, 22) extending in two mutually perpendicular directions to produce a plurality of macro-cells (MC) which each have a particular logic function, the wiring also interconnecting the macro-cells (MC) to complete the device, characterised in that at least one of the plurality of macro-cells (MC) includes arranged along one of the mutually perpendicular directions more of the basic logic cells (BC) than the minimum number which have to be connected together to perform the said particular logic function, in that the wiring passes through a basic cell (BC) of the at least one macro-cell (MC) in a direction perpendicular to the said one direction and in that every basic logic cell (BC) arranged in each of said at least one of the plurality of macro-cells (MC) includes a basic logic element arranged to carry out a logic function and has at least one input/output terminal ($A_1$, $A_2$...; $B_1$, $B_2$,...; $C_1$, $C_2$,...; $D_1$, $D_2$,...; and OUT) connected by the wiring (22), so decreasing the density of occupied terminals of the macro-cell (MC) in the said one direction, thereby providing a greater number of wiring paths across the macro-cell (MC) in the direction perpendicular to the said one direction.

2. A semiconductor device having a gate array structure, wherein a plurality of macro-cells (MC) are arranged on a semiconductor chip, each of said macro-cells (MC) comprising a plurality of interconnected basic cells (BC) and having a logic function, characterised in that at least one of the plurality of macro cells (MC) comprises arranged along one direction more basic cells (BC) than the minimum number that have to be connected together to perform the said logic function and in that wiring lines (22) pass through a basic cell (BC) of the at least one macro-cell (MC) in a direction perpendicular to the one direction and every basic cell (BC) arranged in each of said at least one of the plurality of macro-cells (MC) has at least one input/output terminal ($A_1$, $A_2$,...; $B_1$, $B_2$,...; $C_1$, $C_2$,...; $D_1$, $D_2$,...; and OUT) connected by wiring lines (22), so that the density of occupied terminals of the macro-cell (MC) in a direction transverse to the direction in which wiring lines are to be formed is decreased.

## Patentansprüche

1. Halbleitervorrichtung mit einer Gatearraystruktur, bei welcher das Halbleiterchip eine große Anzahl von Basislogikzellen (BC) umfaßt, die in einer Matrix angeordnet und durch eine Verdrahtung (18, 20, 22) zwischenverbunden sind, welche sich in zwei wechselseitig senkrechten Richtungen erstreckt, um eine Vielzahl von Makrozellen (MC) zu bilden, welche jeweils eine besondere Logikfuntion haben, wobei die Verdrahtung auch die Makrozellen (MC) zwischenverbindet, um die Vorrichtung zu vervollständigen, dadurch gekennzeichnet, daß wenigstens eine der Vielzahl von Makrozellen (MC) längs einer der wechselseitig senkrechten Richtungen angeordnet mehr von den Basislogikzellen (BC) als die Minimalzahl umfaßt, welche miteinander verbunden werden müssen, um die genannte besondere Logikfunktion auszuführen, daß die Verdrahtung durch eine Basiszelle (BC) von der wenigstens einen Makrozelle (MC) in einer Richtung senkrecht zu der genannten einen Richtung verläuft und daß jede Basislogikzelle (BC), die in jeder der genannten wenigstens einen der Vielzahl von Makrozellen (MC) ein Basislogikelement enthält, welches angeordnet ist, um eine Logikfunktion durchzuführen, und wenigstens einen Eingangs/Ausgangsanschluß ($A_1$, $A_2$;..., $B_1$, $B_2$,...; $C_1$, $C_2$,...; $D_1$, $D_2$,...; und OUT) hat, der durch die Verdrahtung (22) verbunden ist, so die Dichte der belegten Anschlüsse der Makrozellen (MC) in der genannten einen Richtung verringernd, wodurch eine größere Anzahl von Verdrehtungswegen quer zu den Makrozellen (MC) in der Richtung senkrecht zu der genannten einen Richtung vorgesehen wird.

2. Halbleitervorrichtung mit einer Gatearraystruktur, bei der eine Veilzahl von Makrozellen (MC) auf einem Halbleiterchip angeordnet sind, jede der genannten Makrozellen (MC) eine Vielzahl von zwischenverbundenen Basiszellen (BC) umfaßt und eine Logikfunktion hat, dadurch gekennzeichnet, daß wenigstens eine der Vielzahl von Makrozellen (MC), large einer Richtung angeordnet, mehr Basiszellen (BC) als die minimale Anzahl umfaßt, die miteinander verbunden sein müssen, um die genannte Logikfunktion auszuführen, und daß Verdrahtungsleitungen (22) durch eine Basiszelle (BC) von der wenigstens einen Makrozelle in einer Richtung senkrecht zu der einen Richtung verlaufen und jede Basiszelle (BC) in jeder von der genannten wenigstens einen von der Vielzahl von Markrozellen (MC) wenig-stens einen Eingangs/Ausgangsanschluß ($A_1$, $A_2$,...; $B_1$, $B_2$,...; $C_1$, $C_2$,...; $D_1$, $D_2$,...; und OUT) hat, der durch Verdrahtungsleitungen (22) so verbunden ist, daß die Dichte der belegten Anschlüsse der Makrozelle (MC) in einer Richtung quer zu der Richtung, in der die Verdrahtungsleitungen gebildet werden sollen, verringert ist.

## Revendications

1. Dispositif semiconducteur possédant une structure de réseau de portes, où une puce semiconductrice comporte un grand nombre de cellules logiques de base (BC) qui sont disposées suivant une matrice et sont interconnectées par un câblage (18, 20, 22) s'étendant suivant deux directions mutuellement perpendiculaires afin de produire plusieurs macrocellules (MC) qui ont chacune une fonction logique particulière, la câblage interconnectant également les macrocellules (MC) de manière à rendre électriquement complet le dispositif, caractérisé en ce qu'au moins une des différentes macrocellules (MC) comporte, disposées le long d'une des directions mutuellement perpendiculaires, un plus grand nombre de cellules logiques de base (BC) que le nombre minimal de cellules de base qui doivent être connectés ensemble pour réaliser ladite fonction logique particulière, en ce que le câblage passe au travers d'une cellule de base (BC) de cette ou de ces macrocellules (MC) suivant une direction perpendiculaire à ladite direction, et en ce que toutes les cellules logiques de base (BC) disposées dans cette macrocellule ou dans chacune de ces macrocellules (MC) comportent un élément logique de base conçu pour effectuer une fonction logique et possèdent au moins une borne d'entrée-sortie ($A_1$, $A_2$,...; $B_1$, $B_2$,...; $C_1$, $C_2$,...; $D_1$, $D_2$,...; et OUT) connectée par le câblage (22), si bien qu'il y a diminution de la densité de bornes occupées de la macrocellule (MC) suivant ladite direction, ce qui produit un plus grand nombre de trajets de câblage au travers de la macrocellule (MC) dans la direction perpendiculaire à ladite direction.

2. Dispositif semiconducteur possédant une structure de réseau de portes, où plusieurs macrocellules (MC) sont disposées sur une puce semiconductrice, chacune desdites macrocellules (MC) comprenant plusieurs cellules de base interconnectées (BC) et ayant une fonction logique, caractérisé en ce qu'au moins une des différentes macrocellules (MC) comprend, disposées suivant une direction, un plus grand nombre de cellules de base (BC) que le nombre minimal de cellules de base qui doivent être connectées ensemble pour réaliser ladite fonction logique, et en ce que des lignes de câblage (22) passent au travers d'une cellule de base (BC) de cette ou de ces macrocellules (MC) suivant une direction perpendiculaire à ladite direction, et toutes les cellules de base (BC) disposées dans cette macrocellule ou dans chacune de ces macro-cellules (MC) possèdent au moins une borne d'entrée-sortie ($A_1$, $A_2$,...; $B_1$, $B_2$,...; $C_1$, $C_2$,...; $D_1$, $D_2$,...; et OUT) connectée par des lignes de câblage (22), de sortie que la densité de bornes occupées du la macrocellule (MC) suivant une direction transversale à la direction dans laquelle des lignes de câblage doivent être formées est diminuée.

Fig. 2

Fig. 1

1

EP 0 072 674 B1

Fig. 3

Fig. 4

Fig. 5

*Fig. 6*

*Fig. 7*